# EUROPEAN PATENT APPLICATION

(11) **EP 3 767 434 A1**
(43) Date of publication of application: **20.01.2021**
(21) Application number: 19920845.5
(22) Date of filing: 28.11.2019
(51) Int. Cl.: G06F 3/01, B06B 1/06, G06F 3/041, H01L 41/053, H01L 41/113, H02N 11/00, H04R 7/04, H04R 17/00, H04R 19/02

(54) **TRANSDUCER DEVICE AND TRANSDUCER SYSTEM**

(30) Priority: 28.03.2019 JP 2019064922; 26.09.2019 JP 2019175769
(71) Applicant: Sumitomo Riko Company Limited, Komaki-shi, Aichi 485-8550 (JP)
(72) Inventor: MURASE, Takanori, Komaki-shi, Aichi 485-8550 (JP); NAKANO, Katsuhiko, Komaki-shi, Aichi 485-8550 (JP); TANAKA, Eiji, Komaki-shi, Aichi 485-8550 (JP)
(74) Representative: Becker, Eberhard
(86) International application number: PCT/JP2019/046496
(87) International publication number: WO 2020/194870

(57) **Abstract**

A transducer device having a configuration capable of expanding the utilization is provided. A transducer device (1) includes a transducer element (11), elastic bodies (12a and 12b) sandwiching the transducer element (11) from two sides and having an elastic modulus smaller than that of the transducer element (11) in a sandwiching direction, a case (14) including an accommodating part (14a) for accommodating a transducer unit (11, 12a, and 12b) and having an opening (14a1), and an elastic plate member (16) including a support part (16a and 16b) supported by the case (14), a facing surface part (16c) positioned at the opening (14a1) of the case (14) and facing the transducer unit (11, 12a, and 12b), and an elastic deformation part (16d and 16e) connecting the support part (16a and 16b) and the facing surface part (16c).

## Description

### Technical Field

The present invention relates to a transducer device and a transducer system.

### Background Art

In the transducer devices described in Japanese Patent Application Laid-Open No. 2018-169712 and Japanese Patent Application Laid-Open No. 2018-93467, a laminate in which a first electrode, a dielectric body, and a second electrode are laminated is formed to be accommodated in a case. In the transducer device described in Japanese Patent Application Laid-Open No. 2018-169712, independent sheets are laminated in multiple layers. In the transducer device described in Japanese Patent Application Laid-Open No. 2018-93467, laminated sheets are wound to form a laminated structure in multiple layers.

Also, as another example of the transducer device, a vibration presentation device is described in PCT International Publication No. WO 2017/110195 and PCT International Publication No. WO 2017/168793. The vibration presentation device described in PCT International Publication No. WO 2017/110195 includes an actuator of an electrostatic type or a piezoelectric type, an elastic body having an elastic modulus smaller than an elastic modulus in a thickness direction of the actuator and disposed on two sides of the actuator, and a cover that holds the elastic body in a compressed state.

The vibration presentation device described in PCT International Publication No. WO 2017/168793 is configured by laminating a first elastic body, an actuator, a second elastic body, a mass, and a third elastic body in that order. An elastic modulus of the first elastic body, the second elastic body, and the third elastic body in the lamination direction is set to be smaller than an elastic modulus of the actuator in the lamination direction. Then, the first elastic body, the second elastic body, and the third elastic body are held by a cover in a compressed state.

### SUMMARY OF INVENTION

### [Technical Problem]

An objective of the present invention is to provide a transducer device and a transducer system having a configuration different from that in conventional cases and having a configuration capable of expanding the utilization. When the utilization is expanded, cost reduction can be achieved and a configuration having versatility can be obtained.

### [Solution to Problem]

### (1. First transducer device)

A first transducer device according to an example of the present invention includes a transducer element formed by laminating a first electrode, one of a dielectric body or a piezoelectric body, and a second electrode in a predetermined reference direction, elastic bodies sandwiching the transducer element from two sides in a sandwiching direction which is at least one of a first sandwiching direction which is a direction coincident with the reference direction and a second sandwiching direction which is a direction perpendicular to the reference direction, and having an elastic modulus smaller than that of the transducer element in the sandwiching direction, a case including an accommodating part which accommodates a transducer unit having the transducer element and the elastic bodies, and an opening in at least one of the sandwiching direction of the transducer unit and a direction perpendicular to the sandwiching direction thereof, and an elastic plate member including a support part supported by the case, a facing surface part positioned at the opening of the case and facing the transducer unit, and an elastic deformation part connecting the support part and the facing surface part.

The facing surface part functions as an input/output member by moving relative to the case. Further, the facing surface part functions as an output member which transmits vibration of the transducer element to the outside via the elastic bodies when the transducer element functions as an actuator, and functions as an input member which transmits vibration from the outside to the transducer element via the elastic bodies when the transducer element functions as a sensor.

That is, the facing surface part of the elastic plate member functions as an input/output member. At this time, the facing surface part compresses the transducer unit due to the elastic force of the elastic deformation part of the elastic plate member. Therefore, the facing surface part reliably functions as an input/output member for the transducer element via the first elastic bodies.

Also, when an elastic body is interposed between the transducer element and the facing surface part, the following functions can be effectively exhibited. Specifically, when the transducer element functions as an actuator, the facing surface part can reliably transmit vibration of the transducer element. When the transducer element functions as a sensor, external vibration can be reliably transmitted from the facing surface part to the transducer element.

Also, devices of various types can be configured by changing relationships between the reference direction, which is a lamination direction of the transducer elements, a position of the opening of the case, and a position of the facing surface part of the elastic plate member. That is, the utilization of the transducer device can be expanded. When the utilization is expanded, cost reduction can be achieved and a configuration having versatility can be obtained.

### (2. Second transducer device)

A second transducer device according to an example of the present invention includes a transducer element formed by laminating a first electrode, one of a dielectric body or a piezoelectric body, and a second electrode in a predetermined reference direction, elastic bodies sandwiching the transducer element from two sides in a first sandwiching direction which is a direction coincident with the reference direction and having an elastic modulus smaller than that of the transducer element in the first sandwiching direction, a case including an accommodating part which accommodates a transducer unit having the transducer element and the elastic bodies, and an opening in the first sandwiching direction of the transducer unit, and an elastic plate member including an elastic deformation part extending in a direction perpendicular to the reference direction from a side surface of the case, and a connecting part connected to a target device at an end portion in an extending direction of the elastic deformation part.

A surface of the transducer unit exposed in an opening direction of the case from the opening of the case is disposed in contact with a facing part of the target device. The facing part of the target device is made to function as an input/output member by being moved relative to the case by deformation of the elastic deformation part of the elastic plate member. The facing part of the target device is made to function as an output member which outputs vibration of the transducer element via the elastic bodies when the transducer element functions as an actuator. The facing part of the target device is made to function as an input member which inputs vibration of the target device to the transducer element via the elastic bodies when the transducer element functions as a sensor.

That is, the target device serving as the input/output member is connected to the elastic plate members and is in contact with the transducer unit. Therefore, the target device is movable relative to the case due to an elastic force of the elastic deformation part of the elastic plate member, and as a result, an amount of compression of the transducer unit changes due to the facing part of the target device. That is, the facing part of the target device can be reliably made to function as an input/output member for the transducer element via the elastic bodies.

Also, when the elastic bodies are interposed between the transducer element and the facing part of the target device, the following functions can be effectively exhibited. Specifically, when the transducer element functions as an actuator, the facing part of the target device can reliably output vibration of the transducer element. When the transducer element functions as a sensor, vibration can be reliably input from the facing part of the target device to the transducer element.

### (3. First transducer system)

A first transducer system according to an example of the present invention includes a plurality of sensors which detects an operation state of a target device, a plurality of actuator devices which is the first transducer device described above, causes the transducer element to function as an actuator, respectively associated with the plurality of sensors, the facing surface part of the elastic plate member is attached to the target device; a drive circuit which is able to drive the plurality of actuator devices; a switching unit which connects the drive circuit to a part of the plurality of actuator devices and switches an object to be connected to the drive circuit, and a control unit which selects the actuator device to be connected to the drive circuit based on detection results of the plurality of sensors and controls the switching unit to connect the drive circuit to the selected actuator device.

According to the transducer system, the plurality of transducer devices is made to function as actuator devices. Then, the plurality of sensors is respectively associated with the plurality of actuator devices, and the actuator devices to be driven differ according to the detected sensors. That is, the actuator devices to be driven differ according to an operation state. At this time, the plurality of actuator devices may all have the same configuration or may be configured differently. That is, the plurality of actuator devices can be in various combinations. Further, when the switching unit and the control unit are provided, it is possible to drive the plurality of actuator devices with one drive circuit. Accordingly, reduction in costs of the transducer system can be achieved.

### (4. Second transducer system)

A second transducer system according to an example of the present invention includes a plurality of sensors which detects an operation state of a target device, a plurality of actuator devices which is the second transducer device described above, causes the transducer element to function as an actuator, respectively associated with the plurality of sensors and the elastic plate member is attached to the target device; a drive circuit which is able to drive the plurality of actuator devices; a switching unit which connects the drive circuit to a part of the plurality of actuator devices and switches an object to be connected to the drive circuit, and a control unit which selects the actuator device to be connected to the drive circuit based on detection results of the plurality of sensors and controls the switching unit to connect the drive circuit to the selected actuator device. Thereby, the same effects as those in the first transducer system are achieved.

### BRIEF DESCRIPTION OF DRAWINGS

Fig. 1 is a perspective view of a transducer device of a first example.
Fig. 2 is an exploded perspective view of the transducer device of the first example.
Fig. 3 is a perspective view of a case constituting the transducer device of the first example from a rear surface side.
Fig. 4 is an enlarged cross-sectional view along line IV-IV of Fig. 1.
Fig. 5 is a view for illustrating a function of a transducer element.
Fig. 6 is a cross-sectional view of a transducer device of a second example.
Fig. 7 is a cross-sectional view of a transducer device of a third example.
Fig. 8 is a perspective view of a transducer device of a fourth example.
Fig. 9 is an exploded perspective view of the transducer device of the fourth example.
Fig. 10 is an enlarged cross-sectional view along line X-X of Fig. 8.
Fig. 11 is a cross-sectional view of a transducer device of a fifth example.
Fig. 12 is a cross-sectional view of a transducer device of a sixth example.
Fig. 13 is a perspective view of a transducer device of a seventh example.
Fig. 14 is an exploded perspective view of the transducer device of the seventh example.
Fig. 15 is a cross-sectional view of the transducer device of the seventh example.
Fig. 16 is a functional block diagram showing a transducer system.

### DESCRIPTION OF EMBODIMENTS

### (1. Overview of transducer device)

A transducer device includes an electrostatic-type transducer element or a piezoelectric-type transducer element. An electrostatic-type transducer element includes a unit laminate formed by laminating a first electrode, a dielectric body, and a second electrode. A piezoelectric-type transducer element includes a unit laminate formed by laminating a first electrode, a piezoelectric body, and a second electrode. A transducer element may be configured by one unit laminate or may be configured by a multi-layer laminate in which a plurality of unit laminates is laminated.

A transducer device can be made to function as an actuator device that generates vibration, sound, or the like. In a case that a transducer device functions as an actuator device, when a voltage is applied to electrodes, a dielectric body or a piezoelectric body is deformed according to an electric potential between the electrodes, and vibration is generated according to the deformation.

When a transducer device is made to function as an actuator device that generates vibration, the transducer device can be applied as, for example, a device that presents tactile vibration to humans, a device that generates vibration having an opposite phase to vibration of a structure for vibration control of the structure, or the like. Also, when a transducer device functions as an actuator device that generates sound, the transducer device can be applied as a speaker that generates a sound wave sensed by human hearing, a sound masking device that cancels noise, or the like.

Particularly, the transducer device is suitable for a low-frequency vibration exciter and a low-frequency sound generator. Accordingly, the transducer device can be effectively utilized as a device that presents tactile vibration to humans, and a speaker that generates a sound wave sensed by human hearing. For example, the transducer device can be suitable for an actuator device that is mounted on a mobile terminal to vibrate the mobile terminal.

Also, the transducer device can be made to function as a sensor device that detects an input from the outside such as a pushing force, vibration, or sound. In this case, an electric potential between the electrodes changes when a dielectric body or a piezoelectric body is deformed due to various inputs from the outside, and the various inputs from the outside are detected by detecting the electric potential between the electrodes. Also, when the transducer device is of an electrostatic type, the transducer device can also be made to function as a sensor device that detects contact or proximity of a conductor. In this case, a capacitance between electrodes changes due to contact or proximity of the conductor, and the contact or proximity of the conductor is detected by detecting a voltage according to the changed capacitance between the electrodes.

### (2. Transducer device 1 of first example)

### (2-1. Configuration)

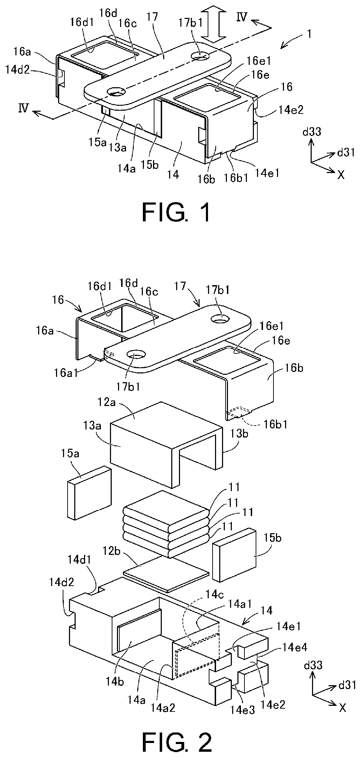

A configuration of a transducer device 1 of a first example will be described with reference to Figs. 1 to 5. The transducer device 1 of the first example is a device that performs input/output in the same direction (d33 direction) as that of an electric field in a transducer element 11 of an electrostatic type or a piezoelectric type.

As illustrated in Fig. 2, the transducer device 1 includes a plurality of transducer elements 11. In the following, the transducer element 11 of an electrostatic type will be taken as an example. However, when the transducer element 11 is of a piezoelectric type, a dielectric body 11b in the following can be replaced with a piezoelectric body.

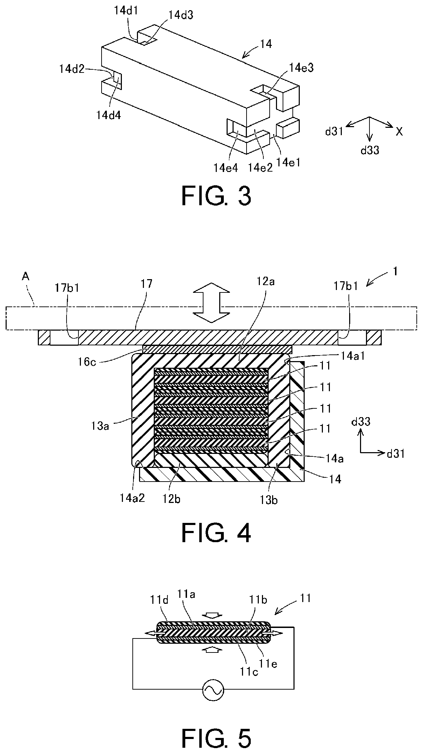

As illustrated in Figs. 4 and 5, the transducer elements 11 is formed of an elastically deformable material such as an elastomer and formed in a flat shape. The transducer element 11 is extendable and contractible in a surface normal direction (d33 direction) and extendable and contractible in a surface direction (d31 direction). As illustrated in Fig. 5, the transducer element 11 extends in the surface direction (d31 direction) when it is compressed in the surface normal direction (d33 direction). On the other hand, the transducer element 11 contracts in the surface direction (d31 direction) when it is extended in the surface normal direction (d33 direction).

The transducer element 11 includes at least a first electrode 11a, the dielectric body 11b, and a second electrode 11c in a direction perpendicular to the flat surface (predetermined reference direction, d33 direction). Then, the transducer element 11 is formed by laminating the first electrode 11a, the dielectric body 11b, and the second electrode 11c in that order. A lamination direction of these is defined as a predetermined reference direction. Further, in the present example, the transducer element 11 includes a first insulating layer 11d that covers the first electrode 11a, and a second insulating layer 11e that covers the second electrode 11c.

Here, in the transducer element 11, the first electrode 11a, the dielectric body 11b, and the second electrode 11c may each be formed as a single layer. The transducer element 11 may also be formed by laminating a plurality of first electrodes 11a, a plurality of dielectric bodies 11b and a plurality of second electrodes 11c. The transducer element 11 may also be formed by laminating the first electrode 11a, the dielectric body 11b, and the second electrode 11c and winding them in a flat roll shape.

The first electrode 11a and the second electrode 11c are formed in a sheet shape from an elastically deformable material such as, for example, an elastomer. The first electrode 11a and the second electrode 11c may be formed of the same material. The first electrode 11a and the second electrode 11c are formed by blending a conductive filler in the elastomer. Therefore, the first electrode 11a and the second electrode 11c have flexibility and a characteristic of being extendable and contractible.

As the elastomer forming the first electrode 11a and the second electrode 11c, for example, silicone rubber, ethylene-propylene copolymer rubber, natural rubber, styrene-butadiene copolymer rubber, acrylonitrile-butadiene copolymer rubber, acrylic rubber, epichlorohydrin rubber, chlorosulfonated polyethylene, chlorinated polyethylene, urethane rubber, or the like can be applied. Also, the conductive filler blended in the first electrode 11a and the second electrode 11c need only be particles having conductivity, and for example, fine particles such as a carbon material or a metal can be applied.

The dielectric body 11b is formed in a sheet shape from an elastically deformable material such as, for example, an elastomer. The dielectric body 11b may be formed thicker than the first electrode 11a and the second electrode 11c. The dielectric body 11b is formed of an elastomer. Therefore, the dielectric body 11b has flexibility and a characteristic of being extendable and contractible.

A material that functions as a dielectric body in an electrostatic body is applied to the dielectric body 11b. Particularly, the dielectric body 11b extends and contracts in a thickness direction and is extendable and contractible in a flat surface direction according to the extension and contraction in the thickness direction. As the elastomer forming the dielectric body 11b, for example, silicone rubber, acrylonitrile-butadiene copolymer rubber, acrylic rubber, epichlorohydrin rubber, chlorosulfonated polyethylene, chlorinated polyethylene, urethane rubber, or the like can be applied.

Therefore, in the transducer element 11, when electric charges accumulated in the first electrode 11a and the second electrode 11c increase, the dielectric body 11b is compressively deformed. That is, as illustrated in Fig. 5, a thickness of the transducer element 11 in the surface normal direction (d33 direction) decreases, and a size in the surface direction (d31 direction) increases. On the other hand, when electric charges accumulated in the first electrode 11a and the second electrode 11c decrease, the dielectric body 11b returns to an original thickness. That is, a thickness of the transducer element 11 increases and a size in the surface direction decreases.

Further, as illustrated in Figs. 2 and 4, a plurality of transducer elements 11 is laminated in the reference direction (d33 direction). However, the transducer device 1 may be configured to include only one transducer element 11.

As illustrated in Figs. 2 and 4, the transducer device 1 further includes a pair of first elastic bodies 12a and 12b and a pair of second elastic bodies 13a and 13b. The pair of first elastic bodies 12a and 12b and the pair of second elastic bodies 13a and 13b are formed in a sheet shape.

When a direction coincident with the reference direction (d33 direction) is referred to as a first sandwiching direction, the pair of first elastic bodies 12a and 12b sandwich the plurality of transducer elements 11 from two sides in the first sandwiching direction. When a direction (d31 direction) that is perpendicular to the reference direction is referred to as a second sandwiching direction, the pair of second elastic bodies 13a and 13b sandwich the plurality of transducer elements 11 from two sides in the second sandwiching direction.

A material having a small elastic modulus E and a small loss factor tan δ can be used for the pair of first elastic bodies 12a and 12b and the pair of second elastic bodies 13a and 13b. In other words, the pair of first elastic bodies 12a and 12b and the second elastic bodies 13a and 13b may be made of a material that is soft and has a low damping characteristic.

Particularly, an elastic modulus of the pair of first elastic bodies 12a and 12b in the surface normal direction is smaller than an elastic modulus of the transducer element 11 in the surface normal direction. An elastic modulus of the pair of second elastic bodies 13a and 13b in the surface direction is smaller than an elastic modulus of the transducer element 11 in the surface direction. Further, the pair of first elastic bodies 12a and 12b and the pair of second elastic bodies 13a and 13b have a loss factor tan δ equal to or less than a loss factor tan δ of the transducer element 11 under a predetermined condition. The predetermined condition means a usage environment in which a temperature is -10 °C to 50 °C and a vibration frequency is 300 Hz or less.

As a material satisfying the above, for example, silicone rubber may be suitable for the pair of first elastic bodies 12a and 12b and the pair of second elastic bodies 13a and 13b. Further, since urethane rubber has a better damping characteristic than silicone rubber, urethane rubber is less suitable for the pair of first elastic bodies 12a and 12b and the pair of second elastic bodies 13a and 13b than silicone rubber. However, it is also possible to use urethane rubber for the pair of first elastic bodies 12a and 12b and the pair of second elastic bodies 13a and 13b depending on a desired characteristic.

Here, the four elastic body elements (12a, 12b, 13a, and 13b), that is, the pair of first elastic bodies 12a and 12b and the pair of second elastic bodies 13a and 13b, may all be integrally formed or may all be separately formed, or some of them may be integrally formed. In the present example, a case that the first elastic body 12a and the pair of second elastic bodies 13a and 13b are integrally formed and formed in an inverted U shape having a corner is illustrated.

Hereinafter, a unit including the transducer element 11, the pair of first elastic bodies 12a and 12b, and the pair of second elastic bodies 13a and 13b is referred to as a transducer unit (11, 12a, 12b, 13a, and 13b).

As illustrated in Figs. 2 to 4, the transducer device 1 further includes a case 14 that accommodates the transducer units (11, 12a, 12b, 13a, and 13b). The case 14 is formed of, for example, a hard resin or a lightweight metal. An outer shape of the case 14 may be formed as, for example, a rectangular parallelepiped having a longitudinal direction in an X direction. However, an outer diameter of the case 14 can be appropriately changed.

The case 14 includes an accommodating part 14a for accommodating the transducer units (11, 12a, 12b, 13a, and 13b) at a center in the longitudinal direction (X direction). The accommodating part 14a has a first opening 14a1 that opens in a direction that is coincident with the first sandwiching direction serving as the reference direction (d33 direction), and a second opening 14a2 that opens in a direction that is coincident with the second sandwiching direction (d31 direction). That is, the accommodating part 14a opens in two directions that are perpendicular to each other and adjacent to each other. Further, in the accommodating part 14a, there is a member that constitutes the accommodating part 14a on a side opposite to the first opening 14a1 and on a side opposite to the second opening 14a2.

Further, a pair of electrode terminals 14b and 14c are disposed on surfaces of the accommodating part 14a facing each other in the X direction. The electrode terminal 14b is electrically connected to the first electrode 11a via an end portion electrode 15a to be described below. Also, the electrode terminal 14c is electrically connected to the second electrode 11c via an end portion electrode 15b to be described below.

Further, the case 14 includes guide grooves 14d1, 14d2, 14e1, and 14e2 on the two end surfaces in the X direction. The guide grooves 14d1 and 14e1 are formed parallel to the first sandwiching direction serving as the reference direction (d33 direction). On the other hand, the guide grooves 14d2 and 14e2 are formed parallel to the second sandwiching direction (d31 direction) perpendicular to the reference direction. The guide grooves 14d1 and 14d2 intersect in a cross shape. Similarly, the guide grooves 14e1 and 14e2 also intersect in a cross shape.

Further, as illustrated in Fig. 3, locking recesses 14d3 and 14e3 are connected to ends of the guide grooves 14d1 and 14e1 on a side opposite to the first opening 14a1. Also, locking recesses 14d4 and 14e4 are connected to ends of the guide grooves 14d2 and 14e2 on a side opposite to the second opening 14a2.

As illustrated in Figs. 2 and 4, the transducer device 1 further includes the pair of end portion electrodes 15a and 15b. The pair of end portion electrodes 15a and 15b are disposed on two sides of the transducer element 11 in a terminal sandwiching direction (X direction). The terminal sandwiching direction (X direction) is a direction perpendicular to the first sandwiching direction serving as the reference direction (d33 direction) and perpendicular to the second sandwiching direction (d31 direction).

Further, the pair of end portion electrodes 15a and 15b are accommodated in the accommodating part 14a of the case 14. The end portion electrode 15a is electrically connected to the first electrode 11a of the transducer element 11 and the electrode terminal 14b of the case 14. The end portion electrode 15b is electrically connected to the second electrode 11c of the transducer element 11 and the electrode terminal 14c of the case 14.

The pair of end portion electrodes 15a and 15b may have elasticity. The pair of end portion electrodes 15a and 15b may be formed by, for example, a combination of an elastic body made of the same material as the first elastic body 12a and an electrode sheet, and the electrode sheet in this case may be an electrode foil or the same material as the first electrode 11a and second electrode 11c described above. Also, as described above, the pair of end portion electrodes 15a and 15b may also be formed of the same material as the first electrode 11a and the second electrode 11c which are elastically deformable and formed in a sheet shape. Since the pair of end portion electrodes 15a and 15b have elasticity, satisfactory electrical connection can be obtained when they are sandwiched between the transducer element 11 and the electrode terminals 14b and 14c of the case 14.

Also, it is also possible to employ a forming method of the pair of end portion electrodes 15a and 15b in which they are filled between the transducer element 11 and the electrode terminals 14b and 14c of the case 14. In this case, the transducer unit (11, 12a, 12b, 13a, and 13b), the case 14, and the pair of end portion electrodes 15a and 15b constitute an integrally formed unit.

The transducer device 1 further includes an elastic plate member 16 as illustrated in Figs. 1, 2, and 4. The elastic plate member 16 is formed of a metal, for example, a spring steel. However, the elastic plate member 16 is not limited to a metal and may be formed of a hard resin.

The elastic plate member 16 includes a pair of support parts 16a and 16b, a facing surface part 16c, and a pair of elastic deformation parts 16d and 16e. The elastic plate member 16 is formed by bending two ends in a longitudinal direction of a spring steel having a long rectangular flat plate shape. The bent ends correspond to the pair of support parts 16a and 16b. Also, a central portion which is not bent corresponds to the facing surface part 16c and the pair of elastic deformation parts 16d and 16e.

The pair of support parts 16a and 16b are portions supported by the case 14. The pair of support parts 16a and 16b face two end surfaces of the case 14. Further, the pair of support parts 16a and 16b include claws 16a1 and 16b1 on distal end sides thereof. The claw 16a1 can be locked in the locking recess 14d3 or 14d4. In the present example, the claw 16a1 is locked in the locking recess 14d3. Further, when the elastic plate member 16 is attached to the case 14, the claw 16a1 is guided by the guide groove 14d1 or 14d2. In the present example, the claw 16a1 is guided by the guide groove 14d1.

Also, the claw 16b1 can be locked in the locking recess 14e3 or 14e4. In the present example, the claw 16b1 is locked in the locking recess 14e3. Further, when the elastic plate member 16 is attached to the case 14, the claw 16b1 is guided by the guide groove 14e1 or 14e2. In the present example, the claw 16b1 is guided by the guide groove 14e1.

The facing surface part 16c is positioned at the first opening 14a1 or the second opening 14a2 of the case 14 and faces the transducer unit (11, 12a, 12b, 13a, and 13b). In the present example, the facing surface part 16c is positioned at the first opening 14a1 and faces the first elastic body 12a.

The pair of elastic deformation parts 16d and 16e connect base ends of the pair of support parts 16a and 16b to two ends of the facing surface part 16c. The pair of elastic deformation parts 16d and 16e are configured as a leaf spring. In the present example, the pair of elastic deformation parts 16d and 16e have a structure in which through holes 16d1 and 16e1 are formed so that an elastic modulus can be adjusted to allow desired elastic deformation.

Then, when the transducer element 11 is in a non-deformed state, the facing surface part 16c compresses the transducer unit (11, 12a, 12b, 13a, and 13b) due to an elastic force of the pair of elastic deformation parts 16d and 16e. In the present example, since the facing surface part 16c is positioned at the first opening 14a1, the facing surface part 16c compresses the transducer unit (11, 12a, 12b, 13a, and 13b) in the first sandwiching direction (d33 direction).

Further, when the transducer element 11 is deformed, the facing surface part 16c is constantly in contact with the transducer unit (11, 12a, 12b, 13a, and 13b) in a pressed state due to the elastic force of the pair of elastic deformation parts 16d and 16e. In the present example, when the transducer element 11 is deformed, the facing surface part 16c is constantly in contact with the first elastic body 12a in a pressed state due to the elastic force of the pair of elastic deformation parts 16d and 16e. That is, the facing surface part 16c moves following deformation of the transducer element 11. As described above, the facing surface part 16c functions as an input/output member by moving relative to the case 14.

As illustrated in Figs. 1, 2, and 4, the transducer device 1 further includes a bracket 17. The bracket 17 is connected to the facing surface part 16c and attached to a mating member A illustrated in Fig. 4. The bracket 17 is formed in a long flat plate shape, and a central portion in a longitudinal direction is laminated on the facing surface part 16c to be connected thereto. The bracket 17 extends in the second sandwiching direction (d31 direction). That is, the bracket 17 extends in a direction perpendicular to a vibration direction of the facing surface part 16c of the elastic plate member 16.

Further, two bolt insertion holes 17b1 and 17b1 for attaching the bracket 17 to the mating member A are formed at two ends in the longitudinal direction of the bracket 17. Further, the attachment structure to the mating member A is not limited to the structure using the bolt insertion holes 17b1 and 17b1.

### (2-2. Operation)

An operation of the transducer device 1 of the first example will be described with reference to Figs. 4 and 5. First, a case in which the transducer device 1 functions as an actuator device will be described.

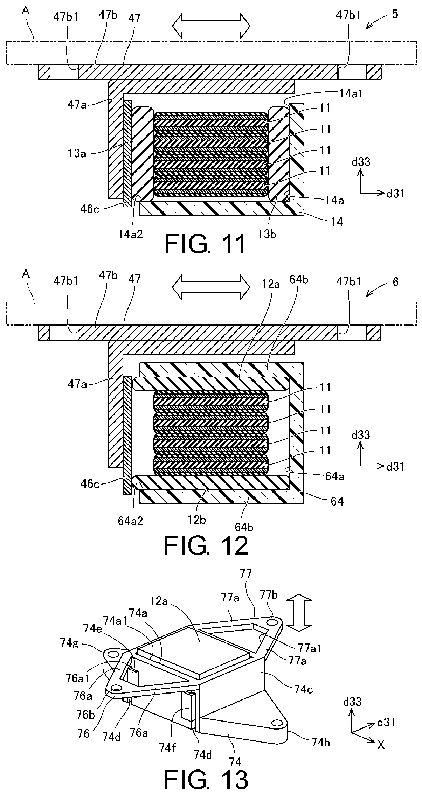

The first electrode 11a and the second electrode 11c are electrically connected to a drive circuit (illustrated in Fig. 13) to be described below via the electrode terminals 14b and 14c and the end portion electrodes 15a and 15b. In this case, a distance between the first electrode 11a and the second electrode 11c changes. Therefore, the transducer element 11 vibrates in the first sandwiching direction (d33 direction).

When the transducer element 11 vibrates in the first sandwiching direction (d33 direction), a force due to the vibration is transmitted to the facing surface part 16c of the elastic plate member 16 via the first elastic bodies 12a and 12b. That is, when the transducer element 11 functions as an actuator, the facing surface part 16c functions as an output member that transmits vibration of the transducer element 11 to the outside (the mating member A) via the first elastic bodies 12a and 12b.

The vibration transmitted to the facing surface part 16c is transmitted to the bracket 17 connected to the facing surface part 16c and further transmitted to the mating member A. Since the facing surface part 16c vibrates in the first sandwiching direction (d33 direction), the bracket 17 also vibrates in the first sandwiching direction (d33 direction). Therefore, the mating member A vibrates in a direction perpendicular to the surface direction.

Also, a case in which the transducer device 1 functions as a sensor device will be described. When the mating member A vibrates in the first sandwiching direction (d33 direction), the bracket 17 vibrates in the first sandwiching direction. According to the vibration of the bracket 17, the facing surface part 16c vibrates in the first sandwiching direction. Here, the facing surface part 16c constantly compresses the transducer unit (11, 12a, 12b, 13a, and 13b) due to an elastic force of the elastic deformation parts 16d and 16e. Then, the vibration in the first sandwiching direction (d33 direction) due to the facing surface part 16c causes a force in the first sandwiching direction (d33 direction) generated in the transducer element 11 to change. Due to the change of the force, the transducer element 11 deforms to extend and contract in the first sandwiching direction (d33 direction).

As described above, the facing surface part 16c functions as an input member that transmits vibration from the outside to the transducer element 11 via the first elastic bodies 12a and 12b. Then, an electric potential between the first electrode 11a and the second electrode 11c changes due to the deformation of extension and contraction of the transducer element 11. Then, it is possible to detect that the mating member A has vibrated in the first sandwiching direction by detecting the change in the electric potential.

### (2-3. Effects)

As described above, the facing surface part 16c compresses the transducer unit (11, 12a, 12b, 13a, and 13b) due to an elastic force of the elastic deformation parts 16d and 16e of the elastic plate member 16. Therefore, the facing surface part 16c reliably functions as an input/output member for the transducer element 11 via the first elastic bodies 12a and 12b.

Also, when the first elastic body 12a is interposed between the transducer element 11 and the facing surface part 16c, the following functions can be effectively exhibited. Specifically, when the transducer element 11 functions as an actuator, the facing surface part 16c can reliably transmit vibration of the transducer element 11. When the transducer element 11 functions as a sensor, external vibration can be reliably transmitted from the facing surface part 16c to the transducer element 11.

### (3. Transducer device 2 of second example)

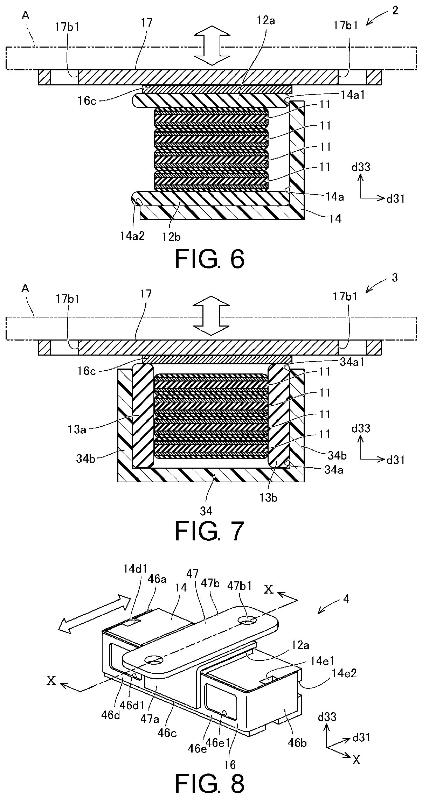

A configuration of a transducer device 2 of a second example will be described with reference to Fig. 6. In the transducer device 2 of the second example, constituents that are the same as those in the transducer device 1 of the first example will be denoted by the same reference signs, and detailed description thereof will be omitted.

The transducer device 2 of the second example is different from that of the first example in elastic body elements (12a and 12b). That is, the transducer device 2 of the second example includes the pair of first elastic bodies 12a and 12b but does not include the pair of second elastic bodies 13a and 13b. When the reference direction (d33 direction) is referred to as a first sandwiching direction, the pair of first elastic bodies 12a and 12b sandwich a plurality of transducer elements 11 from two sides in the first sandwiching direction.

Here, in a direction (d31 direction) perpendicular to the first sandwiching direction, one side of the plurality of transducer elements 11 is exposed, and on the other side thereof there is a gap between them and the accommodating part 14a of the case 14. The transducer device 2 of the second example exhibits substantially the same function as the transducer device 1 of the first example.

Further, although the accommodating part 14a of the case 14 is configured to have the first opening 14a1 and the second opening 14a2, the case 14 in the transducer device 2 of the second example can also be configured not to have the second opening 14a2.

### (4. Transducer device 3 of third example)

A configuration of a transducer device 3 of a third example will be described with reference to Fig. 7. In the transducer device 3 of the third example, constituents that are the same as those in the transducer device 1 of the first example will be denoted by the same reference signs, and detailed description thereof will be omitted.

The transducer device 3 of the third example differs from that of the first example in elastic body elements (13a and 13b) and a case 34. The transducer device 3 of the third example includes a pair of second elastic bodies 13a and 13b but does not include a pair of first elastic bodies 12a and 12b. When a direction perpendicular to the reference direction (d33 direction) is referred to as a second sandwiching direction (d31 direction), the pair of second elastic bodies 13a and 13b sandwich a plurality of transducer elements 11 from two sides in the second sandwiching direction.

Here, in the reference direction (d33 direction), one side of the plurality of transducer elements 11 is exposed, and on the other side thereof there is a gap between them and an accommodating part 34a of the case 34.

The case 34 includes the accommodating part 34a for accommodating a transducer unit (11, 13a, and 13b) at a center portion in a longitudinal direction (X direction). The accommodating part 34a has only a first opening 34a1 that opens on one side in the reference direction (d33 direction). However, the accommodating part 34a does not open in the other direction, that is, in a direction (d31 direction) perpendicular to the reference direction. That is, in a cross section illustrated in Fig. 7, the case 34 includes wall parts 34b and 34b facing each other in the d31 direction. When the transducer element 11 is in a non-deformed state, the wall parts 34b and 34b of the case 34 compress the transducer unit (11, 13a, and 13b) in the second sandwiching direction (d31 direction).

The facing surface part 16c of the elastic plate member 16 is positioned at the first opening 34a1. Then, when the transducer element 11 is in a non-deformed state, the facing surface part 16c compresses the second elastic bodies 13a and 13b in the reference direction (d33 direction) due to an elastic force of the elastic deformation parts 16d and 16e.

An operation of the transducer device 3 of the third example will be described. First, a case in which the transducer device 3 functions as an actuator device will be described. The first electrode 11a and the second electrode 11c are electrically connected to a drive circuit (illustrated in Fig. 13) to be described below via the electrode terminals 14b and 14c and the end portion electrodes 15a and 15b. Then, a distance between the first electrode 11a and the second electrode 11c changes. Therefore, the transducer element 11 also vibrates in the second sandwiching direction (d31 direction) in addition to vibrating in the reference direction (d33 direction).

When the transducer element 11 vibrates in the second sandwiching direction (d31 direction), a force due to the vibration is transmitted to the second elastic bodies 13a and 13b. Since the second elastic bodies 13a and 13b are sandwiched between the wall parts 34b and 34b of the case 34, a deformation operation of the second elastic bodies 13a and 13b is transmitted to the facing surface part 16c of the elastic plate member 16. That is, when the transducer element 11 functions as an actuator, the facing surface part 16c functions as an output member that transmits vibration of the transducer element 11 to the outside (the mating member A) via the second elastic bodies 13a and 13b.

The vibration transmitted to the facing surface part 16c is transmitted to the bracket 17 connected to the facing surface part 16c and further transmitted to the mating member A. Since the facing surface part 16c vibrates in the reference direction (d33 direction), the bracket 17 also vibrates in the reference direction (d33 direction). Therefore, the mating member A vibrates in a direction perpendicular to the surface direction.

Also, a case in which the transducer device 3 functions as a sensor device will be described. When the mating member A vibrates in the reference direction (d33 direction), the bracket 17 vibrates in the reference direction. According to the vibration of the bracket 17, the facing surface part 16c vibrates in the reference direction. Here, the facing surface part 16c constantly compresses the transducer unit (11, 13a, and 13b) due to the elastic force of the elastic deformation parts 16d and 16e. Then, the vibration in the reference direction (d33 direction) due to the facing surface part 16c causes a force in the second sandwiching direction (d31 direction) generated in the transducer element 11 to change via the second elastic bodies 13a and 13b. Due to the change of the force, the transducer element 11 deforms to extend and contract in the reference direction (d33 direction).

As described above, the facing surface part 16c functions as an input member that transmits vibration from the outside to the transducer element 11 via the second elastic bodies 13a and 13b. Then, an electric potential between the first electrode 11a and the second electrode 11c changes due to the deformation of extension and contraction of the transducer element 11. Then, it is possible to detect that the mating member A has vibrated in the reference direction by detecting the change in the electric potential.

### (5. Transducer device 4 of fourth example)

### (5-1. Configuration)

A configuration of the transducer device 4 of a fourth example will be described with reference to Figs. 8 to 10. The transducer device 4 of the fourth example is a device that performs input/output in a direction (d31 direction) perpendicular to an electric field in the transducer element 11 of an electrostatic type or a piezoelectric type. In the transducer device 4 of the fourth example, constituents that are the same as those in the transducer device 1 of the first example will be denoted by the same reference signs, and detailed description thereof will be omitted.

The transducer device 4 of the fourth example differs from that of the first example in an elastic plate member 46 and a bracket 47. Here, in the transducer device 4 of the fourth example, the transducer unit (11, 12a, 12b, 13a, and 13b), the case 14, and the pair of end portion electrodes 15a and 15b are common to those in the first example. That is, in the fourth example, although the input/output direction is different from that in the first example, parts are used in common. The differences therebetween will be described below.

The elastic plate member 46 includes a pair of support parts 46a and 46b, a facing surface part 46c, and a pair of elastic deformation parts 46d and 46e. The elastic plate member 46 is formed by bending two ends in a longitudinal direction of a spring steel having a long rectangular flat plate shape. The bent ends correspond to the pair of support parts 46a and 46b. Also, a central portion which is not bent corresponds to the facing surface part 46c and the pair of elastic deformation parts 46d and 46e.

The pair of support parts 46a and 46b are portions supported by the case 14. The pair of support parts 46a and 46b face two end surfaces of the case 14. Further, the pair of support parts 46a and 46b include claws 46a1 and 46b 1 on distal end sides thereof. The claw 46a1 can be locked in the locking recess 14d3 or 14d4. In the present example, the claw 46a1 is locked in the locking recess 14d4. Further, when the elastic plate member 46 is attached to the case 14, the claw 46a1 is guided by the guide groove 14d1 or 14d2. In the present example, the claw 46a1 is guided by the guide groove 14d2.

Also, the claw 46b1 can be locked in the locking recess 14e3 or 14e4. In the present example, the claw 46b1 is locked in the locking recess 14e4. Further, when the elastic plate member 46 is attached to the case 14, the claw 46b1 is guided by the guide groove 14e1 or 14e2. In the present example, the claw 46b1 is guided by the guide groove 14e2.

The facing surface part 46c is positioned at the first opening 14a1 or the second opening 14a2 of the case 14 and faces the transducer unit (11, 12a, 12b, 13a, and 13b). In the present example, the facing surface part 46c is positioned at the second opening 14a2 and faces the second elastic body 13a.

The pair of elastic deformation parts 46d and 46e connect base ends of the pair of support parts 46a and 46b to two ends of the facing surface part 46c. In the present example, the pair of elastic deformation parts 46d and 46e have a structure in which through holes 46d1 and 46e1 are formed so that an elastic modulus can be adjusted to allow desired elastic deformation.

Then, when the transducer element 11 is in a non-deformed state, the facing surface part 46c compresses the transducer unit (11, 12a, 12b, 13a, and 13b) due to an elastic force of the pair of elastic deformation parts 46d and 46e. In the present example, since the facing surface part 46c is positioned at the second opening 14a2, the facing surface part 46c compresses the transducer unit (11, 12a, 12b, 13a, and 13b) in the second sandwiching direction (d31 direction).

Further, when the transducer element 11 is deformed, the facing surface part 46c is constantly in contact with the transducer unit (11, 12a, 12b, 13a, and 13b) in a pressed state due to the elastic force of the pair of elastic deformation parts 46d and 46e. In the present example, when the transducer element 11 is deformed, the facing surface part 46c is constantly in contact with the second elastic body 13a in a pressed state due to the elastic force of the pair of elastic deformation parts 46d and 46e. That is, the facing surface part 46c moves following the deformation of the transducer element 11. As described above, the facing surface part 46c functions as an input/output member by moving relative to the case 14.

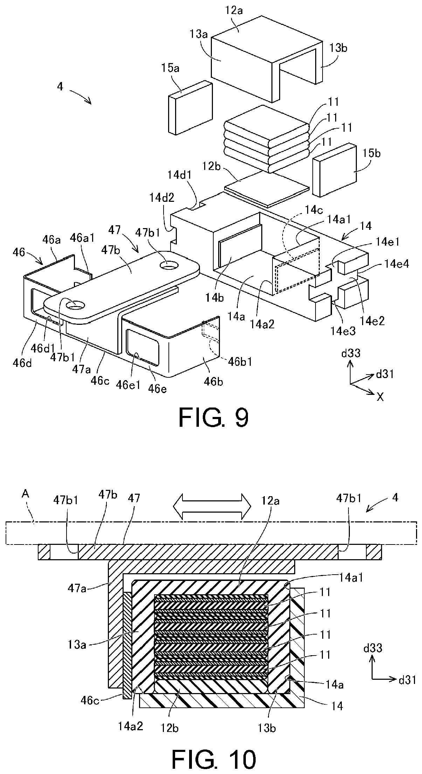

The bracket 47 is connected to the facing surface part 46c and attached to the mating member A illustrated in Fig. 10. The bracket 47 includes an L-shaped member 47a and a flat plate-shaped attaching member 47b. One surface of the L-shaped member 47a is laminated on the facing surface part 46c to be connected thereto. The other surface of the L-shaped member 47a is positioned to face the first opening 14a1. Further, as illustrated in Fig. 10, the other surface of the L-shaped member 47a faces the first elastic body 12a with a gap therebetween.

The attaching member 47b is formed in a long flat plate shape, and a central portion in a longitudinal direction is connected to the other surface of the L-shaped member 47a. Then, the attaching member 47b extends in the second sandwiching direction (d31 direction). That is, the attaching member 47b extends in a direction parallel to a vibration direction of the facing surface part 46c of the elastic plate member 46.

Further, two bolt insertion holes 47b1 and 47b1 for attaching the attaching member 47b to the mating member A are formed at two ends in the longitudinal direction of the attaching member 47b. Further, the attachment structure to the mating member A is not limited to the structure using the bolt insertion holes 47b1 and 47b1.

### (5-2. Operation)

An operation of the transducer device 4 of the fourth example will be described with reference to Fig. 10. First, a case in which the transducer device 4 functions as an actuator device will be described. The first electrode 11a and the second electrode 11c are electrically connected to a drive circuit (illustrated in Fig. 13) to be described below via the electrode terminals 14b and 14c and the end portion electrodes 15a and 15b. Then, a separation distance between the first electrode 11a and the second electrode 11c changes. Therefore, the transducer element 11 also vibrates in the second sandwiching direction (d31 direction) in addition to vibrating in the reference direction (d33 direction).

When the transducer element 11 vibrates in the second sandwiching direction (d31 direction), a force due to the vibration is transmitted to the facing surface part 46c of the elastic plate member 46 via the second elastic bodies 13a and 13b. That is, when the transducer element 11 functions as an actuator, the facing surface part 46c functions as an output member that transmits vibration of the transducer element 11 to the outside via the second elastic bodies 13a and 13b.

The vibration transmitted to the facing surface part 46c is transmitted to the bracket 47 connected to the facing surface part 46c and further transmitted to the mating member A. Since the facing surface part 46c vibrates in the second sandwiching direction (d31 direction), the bracket 47 also vibrates in the second sandwiching direction (d31 direction). Therefore, the mating member A vibrates in the surface direction.

Also, a case in which the transducer device 1 functions as a sensor device will be described. When the mating member A vibrates in the second sandwiching direction (d31 direction), the bracket 47 vibrates in the second sandwiching direction. According to the vibration of the bracket 47, the facing surface part 46c vibrates in the second sandwiching direction. Here, the facing surface part 46c constantly compresses the transducer unit (11, 12a, 12b, 13a, and 13b) due to the elastic force of the elastic deformation parts 46d and 46e. Then, the vibration in the second sandwiching direction (d31 direction) due to the facing surface part 46c causes a force in the second sandwiching direction (d31 direction) generated in the transducer element 11 to change. Due to the change of the force, the transducer element 11 deforms to extend and contract in the second sandwiching direction (d31 direction).

As described above, the facing surface part 46c functions as an input member that transmits vibration from the outside to the transducer element 11 via the second elastic bodies 13a and 13b. Then, an electric potential between the first electrode 11a and the second electrode 11c changes due to the deformation of extension and contraction of the transducer element 11. Then, it is possible to detect that the mating member A has vibrated in the second sandwiching direction by detecting the change in the electric potential.

### (5-3. Effects)

Also in the transducer device 4 of the fourth example, the same effects as those in the first example are achieved. Further, the accommodating part 14a of the case 14 includes the first opening 14a1 and the second opening 14a2, and the elastic body elements (12a, 12b, 13a, and 13b) are disposed on the entire circumference of the transducer element 11 in the circumferential direction. Thereby, the transducer unit (11, 12a, 12b, 13a, and 13b), the case 14, and the pair of end portion electrodes 15a and 15b can be used in common.

Particularly, when a relationship between the case 14 and the elastic plate member 16 or 46 is made as follows, using parts in common is achieved. That is, the case 14 is made possible to support the support parts 16a and 16b or 46a and 46b so that the facing surface part 16c or 46c is positioned at the first opening 14a1. In addition, the case 14 is made possible to support the support parts 16a and16b or 46a and 46b so that the facing surface part 16c or 46c is positioned at the second opening 14a2.

As described above, devices of various types can be configured by changing relationships between the reference direction (d31 direction), which is the lamination direction of the transducer elements 11, a position of the opening of the case 14, and a position of the facing surface part 16c or 46c of the elastic plate member 16 or 46. That is, the utilization of the transducer devices 1 and 4 can be expanded. When the utilization is expanded, cost reduction can be achieved and a configuration having versatility can be obtained.

### (6. Transducer device 5 of fifth example)

A configuration of a transducer device 5 of a fifth example will be described with reference to Fig. 11. In the transducer device 5 of the fifth example, constituents that are the same as those in the transducer device 4 of the fourth example will be denoted by the same reference signs, and detailed description thereof will be omitted.

The transducer device 5 of the fifth example differs from that of the fourth example in elastic body elements (13a and 13b). That is, the transducer device 5 of the fifth example includes the pair of second elastic bodies 13a and 13b but does not include the pair of first elastic bodies 12a and 12b. When a direction perpendicular to the reference direction (d33 direction) is referred to as a second sandwiching direction (d31 direction), the pair of second elastic bodies 13a and 13b sandwich a plurality of transducer elements 11 from two sides in the second sandwiching direction.

Here, in the reference direction (d33 direction), one side of the plurality of transducer elements 11 is exposed, and on the other side thereof there is a gap between them and the accommodating part 14a of the case 14. The transducer device 5 of the fifth example exhibits substantially the same function as the transducer device 4 of the fourth example.

Further, although the accommodating part 14a of the case 14 has the first opening 14a1 and the second opening 14a2, the case 14 in the transducer device 5 of the fifth example can also be configured not to have the first opening 14a1.

### (7. Transducer device 6 of sixth example)

A configuration of a transducer device 6 of a sixth example will be described with reference to Fig. 12. In the transducer device 6 of the sixth example, constituents that are the same as those in the transducer device 4 of the fourth example will be denoted by the same reference signs, and detailed description thereof will be omitted.

The transducer device 6 of the sixth example differs from that of the fourth example in elastic body elements (12a and 12b) and a case 64. The transducer device 6 of the sixth example includes the pair of first elastic bodies 12a and 12b but does not have the pair of second elastic bodies 13a and 13b. When a direction coincident with the reference direction (d33 direction) is referred to as a first sandwiching direction, the pair of first elastic bodies 12a and 12b sandwich a plurality of transducer elements 11 from two sides in the first sandwiching direction.

Here, in a direction (d31 direction) perpendicular to the reference direction (d33 direction), one side of the plurality of transducer elements 11 is exposed, and on the other side thereof there is a gap between them and an accommodating part 64a of the case 64.

The case 64 includes the accommodating part 64a for accommodating a transducer unit (11, 12a, and 12b) at a center portion in a longitudinal direction (X direction). The accommodating part 64a has only a second opening 64a2 that opens on one side in the direction (d31 direction) perpendicular to the reference direction. However, the accommodating part 64a does not open in the other directions, that is, in the reference direction (d33 direction). That is, in a cross section illustrated in Fig. 12, the case 64 includes wall parts 64b and 64b facing each other in the d33 direction. When the transducer element 11 is in a non-deformed state, the wall parts 64b and 64b of the case 64 compress the transducer unit (11, 12a, and 12b) in the first sandwiching direction (d33 direction).

The facing surface part 46c of the elastic plate member 46 is positioned at the second opening 64a2. Then, when the transducer element 11 is in a non-deformed state, the facing surface part 46c compresses the first elastic bodies 12a and 12b in the direction (d31 direction) perpendicular to the reference direction due to an elastic force of the elastic deformation parts 46d and 46e.

An operation of the transducer device 6 of the sixth example will be described. First, a case in which the transducer device 6 functions as an actuator device will be described. The first electrode 11a and the second electrode 11c are electrically connected to a drive circuit (illustrated in Fig. 13) to be described below via the electrode terminals 14b and 14c and the end portion electrodes 15a and 15b. Then, a distance between the first electrode 11a and the second electrode 11c changes. Therefore, the transducer element 11 vibrates in the reference direction (d33 direction).

When the transducer element 11 vibrates in the reference direction (d33 direction), a force due to the vibration is transmitted to the first elastic bodies 12a and 12b. Since the first elastic bodies 12a and 12b are sandwiched between the wall parts 64b and 64b of the case 64, a deformation operation of the first elastic bodies 12a and 12b is transmitted to the facing surface part 46c of the elastic plate member 46. That is, when the transducer element 11 functions as an actuator, the facing surface part 46c functions as an output member that transmits vibration of the transducer element 11 to the outside (the mating member A) via the first elastic bodies 12a and 12b.

The vibration transmitted to the facing surface part 46c is transmitted to the bracket 47 connected to the facing surface part 46c and further transmitted to the mating member A. Since the facing surface part 46c vibrates in the direction (d31 direction) perpendicular to the reference direction, the bracket 47 also vibrates in the same direction (d31 direction). Therefore, the mating member A vibrates in the surface direction.

Also, a case in which the transducer device 6 functions as a sensor device will be described. When the mating member A vibrates in the direction (d31 direction) perpendicular to the reference direction, the bracket 47 vibrates in a direction perpendicular to the reference direction. According to the vibration of the bracket 47, the facing surface part 46c vibrates in a direction perpendicular to the reference direction. Here, the facing surface part 46c constantly compresses the transducer unit (11, 12a, and 12b) due to the elastic force of the elastic deformation parts 46d and 46e. Then, the vibration in the direction (d31 direction) perpendicular to the reference direction due to the facing surface part 46c causes a force in the first sandwiching direction (d33 direction) generated in the transducer element 11 to change via the first elastic bodies 12a and 12b. Due to the change of the force, the transducer element 11 deforms to extend and contract in the reference direction (d33 direction).

As described above, the facing surface part 46c functions as an input member that transmits vibration from the outside to the transducer element 11 via the first elastic bodies 12a and 12b. Then, an electric potential between the first electrode 11a and the second electrode 11c changes due to the deformation of extension and contraction of the transducer element 11. Then, it is possible to detect that the mating member A has vibrated in a direction perpendicular to the reference direction by detecting the change in the electric potential.

### (8. Transducer device of seventh example)

### (8-1. Configuration)

A configuration of a transducer device 7 of a seventh example will be described with reference to Figs. 13 to 15. The transducer device 7 of the seventh example is a device that performs input/output in the same direction (d33 direction) as that of an electric field in the transducer element 11 of an electrostatic type or a piezoelectric type as in the first example. In the transducer device 7 of the seventh example, constituents that are the same as those in the transducer device 1 of the first example will be denoted by the same reference signs, and detailed description thereof will be omitted.

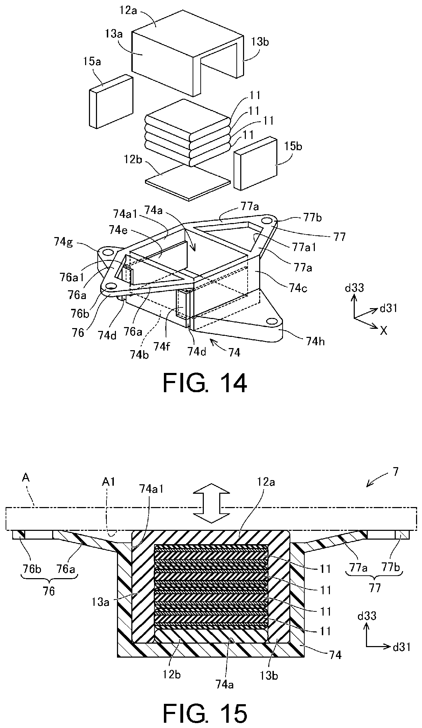

The transducer device 7 of the seventh example differs from that of the first example in a case 74 and elastic plate members 76 and 77 and differs therefrom in that a bracket is not provided. Here, as illustrated in Fig. 14, in the transducer device 7 of the seventh example, the transducer unit (11, 12a, 12b, 13a, and 13b) and the pair of end portion electrodes 15a and 15b are common to those in the first example.

The case 74 includes an accommodating part 74a. The accommodating part 74a has an opening 74a1 that opens in the first sandwiching direction that is coincident with the reference direction (d33 direction). That is, the case 74 includes a bottom portion 74b and a side wall 74c extending over the entire circumference. In the present example, the case 74 is formed as a rectangular parallelepiped. That is, the case 74 has a rectangular bottom portion 74b and four side walls 74c.

A transducer unit (11, 12a, 12b, 13a, and 13b) is inserted from the opening 74a1 of the accommodating part 74a to be accommodated in the accommodating part 74a. Further, a part of the transducer unit (11, 12a, 12b, 13a, and 13b) in the reference direction (d33 direction) protrudes to the outside from the opening 74a1 of the case 74. Then, a surface of the transducer unit (11, 12a, 12b, 13a, and 13b) exposed in an opening direction of the case 74 from the opening 74a1 of the case 74 is disposed in contact with a facing part A1 of the target device A (illustrated in Fig. 15).

The case 74 further includes a pair of slits 74d that penetrate an inner surface (a surface on the accommodating part 74a side) and an outer surface (an exposed side surface) of the side wall 74c. The pair of slits 74d are formed to extend from a surface of the accommodating part 74a. In the present example, the pair of slits 74d are formed in the same one wall of the four side walls 74c. Therefore, the case 74 opens to the outside only through the opening 74a1 and the pair of slits 74d, and the other portions are closed.

A pair of electrode terminals 74e and 74f are disposed on surfaces of the accommodating part 74a facing each other in the X direction. The electrode terminal 74e is electrically connected to the first electrode 11a via the end portion electrode 15a. Further, the electrode terminal 74e extends from the accommodating part 74a to an outer surface of the side wall 74c through the slit 74d and is exposed on an outer surface of the case 74. Also, the electrode terminal 74f is electrically connected to the second electrode 11c via the end portion electrode 15b. Further, the electrode terminal 74f extends from the accommodating part 74a to an outer surface of the side wall 74c through the slit 74d and is exposed on an outer surface of the case 74. Portions exposed on the outer surfaces of the pair of electrode terminals 74e and 74f are attached to the side wall 74c. That is, the pair of electrode terminals 74e and 74f are bent at a right angle.

The case 74 further includes a pair of mounting flanges 74g and 74h. The mounting flanges 74g and 74h extend in a direction (X direction or d31 direction) perpendicular to the reference direction (d33 direction) from the bottom portion 74b side of the outer surface (side surface) of the side wall 74c. In the present example, the pair of mounting flanges 74g and 74h extend in the X direction. The pair of mounting flanges 74g and 74h are fixed to a fixing member (not illustrated).

The transducer device 7 further includes a pair of elastic plate members 76 and 77. The pair of elastic plate members 76 and 77 include a pair of elastic deformation parts 76a and 77a and a pair of connecting parts 76b and 77b. The elastic deformation parts 76a and 77a extend in a direction (X direction or d31 direction) perpendicular to the reference direction (d33 direction) from the outer surface (side surface) of the side wall 74c of the case 74. In the present example, the elastic deformation parts 76a and 77a extend in the d31 direction which is a direction different from that of the pair of mounting flanges 74g and 74h. Further, the elastic deformation parts 76a and 77a extend outward from edges on the opening 74a1 side of the side surfaces of the case 74.

The elastic deformation parts 76a and 77a are formed of a leaf spring. In the present example, the elastic deformation parts 76a and 77a have a structure in which through holes 76a1 and 77a1 are formed so that an elastic modulus can be adjusted to allow desired elastic deformation. Also, in the present example, the elastic deformation parts 76a and 77a each form a so-called triangular shape in which base end sides are spaced apart and distal end surfaces are close to each other. The connecting parts 76b and 77b are positioned at distal end portions in directions in which the elastic deformation parts 76a and 77a extend and are connected to the target device A (illustrated in Fig. 15).

As illustrated in Fig. 15, in an initial state in which the target device A is connected to the connecting parts 76b and 77b of the pair of elastic plate members 76 and 77, the transducer unit (11, 12a, 12b, 13a, and 13b) is compressed in the first sandwiching direction by the facing part A1 of the target device A.

### (8-2. Operation)

An operation of the transducer device 7 of the seventh example is substantially the same as that of the transducer device 1 of the first example. When the transducer device 7 functions as an actuator device, the facing part A1 of the target device A is made to function as an output member that outputs vibration of the transducer element 11 via the first elastic bodies 12a and 12b. Also, when the transducer device 7 functions as a sensor device, the facing part A1 of the target device A functions as an input member that inputs vibration of the target device A to the transducer element 11 via the first elastic bodies 12a and 12b.

### (8-3. Effects)

The target device A serving as the input/output member is connected to the elastic plate members 76 and 77 and is in contact with the transducer unit (11, 12a, 12b, 13a, and 13b). Therefore, the target device A is movable relative to the case 74 due to an elastic force of the elastic deformation parts 76a and 77a of the elastic plate members 76 and 77, and as a result, an amount of compression of the transducer unit (11, 12a, 12b, 13a, and 13b) changes due the facing part A1 of the target device A. That is, the facing part A1 of the target device A can be reliably made to function as an input/output member for the transducer element 11 via the first elastic bodies 12a and 12b.

Also, when the first elastic bodies 12a and 12b are interposed between the transducer element 11 and the facing part A1 of the target device A, the following functions can be effectively exhibited. That is, when the transducer element 11 functions as an actuator, the facing part A1 of the target device A can reliably output vibration of the transducer element 11. When the transducer element 11 functions as a sensor, vibration can be reliably input from the facing part A1 of the target device A to the transducer element 11.

### (9. Example of transducer system 100)

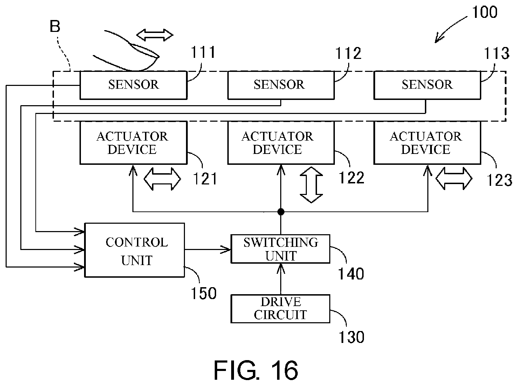

A configuration of a transducer system 100 will be described with reference to Fig. 16. The transducer system 100 utilizes the above-described transducer devices 1 to 7 as actuator devices.

As shown in Fig. 16, the transducer system 100 includes a plurality of sensors 111 to 113, a plurality of actuator devices 121 to 123, one drive circuit 130, one switching unit 140, and one control unit 150.

The plurality of sensors 111 to 113 may detect, for example, an operation state of a target device B. For example, the target device B may be a touch panel or the like, and the plurality of sensors 111 to 113 may be position detecting sensors incorporated in the touch panel. The target device B can be targets of various types other than a touch panel. For example, the target device B can be applied to a surface of a pointing device such as a mouse or a joystick. Also, the target device B can also be applied to devices such as virtual reality (VR) or augmented reality (AR).

For the plurality of actuator devices 121 to 123, the transducer devices 1 to 6 described above are applied as the actuator devices. That is, the transducer element 11 is made to function as the actuator.

Here, a part of the plurality of actuator devices 121 to 123 employs any one of the transducer devices 1 to 3 of the first to third examples, and another part thereof employs any one of the transducer devices 4 to 6 of the fourth to sixth examples. That is, a part of the plurality of actuator devices 121 to 123 is caused to vibrate the target device B in a surface normal direction (d33 direction), and another part thereof is caused to vibrate the target device B in a surface direction (d31 direction). Further, it is also possible to apply an actuator device of the same type to all of the plurality of actuator devices 121 to 123.

Further, the brackets 17 or 47 of the plurality of actuator devices 121 to 123 are attached to the target device B. However, when the plurality of actuator devices 121 to 123 is configured by the transducer device 7 of the seventh example, the connecting parts 76b and 77b of the pair of elastic plate members 76 and 77 are connected to the target device B. Also, the plurality of actuator devices 121 to 123 is respectively associated with the plurality of sensors 111 to 113. That is, the actuator device 121 is associated with the sensor 111, and the same applies to the other actuator devices.

The drive circuit 130 is a circuit capable of driving the plurality of actuator devices 121 to 123. The switching unit 140 connects the drive circuit 130 to a part of the plurality of actuator devices 121 to 123 and switches an object to be connected to the drive circuit 130.

The control unit 150 controls the switching unit 140. Specifically, the control unit 150 selects the actuator devices 121 to 123 to be connected to the drive circuit 130 based on detection results of the plurality of sensors 111 to 113. Then, the control unit 150 controls the switching unit 140 to connect the drive circuit 130 to the selected actuator devices 121 to 123.

A case in which the sensor 111 detects contact of a human finger will be taken as an example. In this case, when the sensor 111 detects an object, the control unit 150 controls the switching unit 140 to connect the drive circuit 130 and the actuator device 121. Since the actuator device 121 is a device that vibrates in the surface direction (d31 direction), vibration in the surface direction is applied to the vicinity of the sensor 111 in the target device B. Tactile vibration can be presented to a human finger in contact with the target device B.

According to the transducer system 100, the plurality of transducer devices 1 to 6 is made to function as the actuator devices 121 to 123. Then, the plurality of sensors 111 to 113 is respectively associated with the plurality of actuator devices 121 to 123, and the actuator devices 121 to 123 to be driven differ according to the detected sensors 111 to 113. That is, the actuator devices 121 to 123 to be driven differ according to an operation state. At this time, the plurality of actuator devices 121 to 123 may all have the same configuration or may be configured differently. That is, the plurality of actuator devices 121 to 123 can be in various combinations. Further, when the switching unit 140 and the control unit 150 are provided, it is possible to drive the plurality of actuator devices 121 to 123 with one drive circuit 130. Accordingly, reduction in costs of the transducer system 100 can be achieved.

### [Reference Signs List]

- 1, 2, 3, 4, 5, 6, 7: Transducer device
- 11: Transducer element
- 11a: First electrode
- 11b: Dielectric body
- 11c: Second electrode
- 12a, 12b: First elastic body
- 13a, 13b: Second elastic body
- 14, 34, 64, 74: Case
- 14a, 34a, 64a, 74a: Accommodating part
- 14a1, 34a1, 74a1: First opening
- 14a2, 64a2: Second opening
- 14b, 14c,: 74e, 74f Electrode terminal
- 14d1, 14d2, 14e1, 14e2: Guide groove
- 14d3, 14d4, 14e3, 14e4: Locking recess
- 15a, 15b: End portion electrode
- 16, 46: Elastic plate member
- 16a, 16b, 46a, 46b: Support part
- 16a1, 16b1, 46a1, 46b1: Claw
- 16c, 46c: Facing surface part
- 16d, 16e, 46d, 46e: Elastic deformation part
- 17, 47: Bracket
- 34b, 34b, 64b, 64b: Wall part
- 74d: Slit
- 76, 77: Elastic plate member
- 76a, 77a: Elastic deformation part
- 76b, 77b: Connecting part
- 100: Transducer system
- 111 to 113: Sensor
- 121 to 123: Actuator device
- 130: Drive circuit
- 140: Switching unit
- 150: Control unit
- A: Mating member
- B: Target device

## Claims

1. A transducer device comprising:
a transducer element formed by laminating a first electrode, one of a dielectric body or a piezoelectric body, and a second electrode in a predetermined reference direction;
elastic bodies sandwiching the transducer element from two sides in a sandwiching direction which is at least one of a first sandwiching direction which is a direction coincident with the reference direction and a second sandwiching direction which is a direction perpendicular to the reference direction, and having an elastic modulus smaller than that of the transducer element in the sandwiching direction;
a case including an accommodating part which accommodates a transducer unit having the transducer element and the elastic bodies, and an opening in at least one of the sandwiching direction of the transducer unit and a direction perpendicular to the sandwiching direction thereof; and
an elastic plate member including a support part supported by the case, a facing surface part positioned at the opening of the case and facing the transducer unit, and an elastic deformation part connecting the support part and the facing surface part,
wherein the facing surface part
functions as an input/output member by moving relative to the case,
functions as an output member which transmits vibration of the transducer element to an outside via the elastic bodies when the transducer element functions as an actuator, and
functions as an input member which transmits vibration from the outside to the transducer element via the elastic bodies when the transducer element functions as a sensor.

2. The transducer device according to claim 1, wherein
the elastic bodies sandwich the transducer element from the two sides in the first sandwiching direction coincident with the reference direction,
the case has the opening in at least the first sandwiching direction, and
the facing surface part compresses the transducer unit in the first sandwiching direction due to an elastic force of the elastic deformation part when the transducer element is in a non-deformed state.

3. The transducer device according to claim 1, wherein
the elastic bodies sandwich the transducer element from the two sides in the second sandwiching direction perpendicular to the reference direction,
the case has the opening in the reference direction and compresses the transducer unit in the second sandwiching direction when the transducer element is in a non-deformed state, and
the facing surface part compresses the elastic bodies in the reference direction due to an elastic force of the elastic deformation part when the transducer element is in a non-deformed state.

4. The transducer device according to claim 1, wherein
the elastic bodies sandwich the transducer element from the two sides in the second sandwiching direction perpendicular to the reference direction,
the case has the opening in at least the second sandwiching direction,
the facing surface part compresses the transducer unit in the second sandwiching direction due to an elastic force of the elastic deformation part when the transducer element is in a non-deformed state.

5. The transducer device according to claim 1, wherein
the elastic bodies sandwich the transducer element from the two sides in the first sandwiching direction coincident with the reference direction,
the case has the opening in a direction perpendicular to the first sandwiching direction and compresses the transducer unit in the first sandwiching direction when the transducer element is in a non-deformed state, and
the facing surface part compresses the elastic bodies in the direction perpendicular to the first sandwiching direction due to an elastic force of the elastic deformation part when the transducer element is in a non-deformed state.

6. The transducer device according to any one of claims 1 to 3, further comprising a bracket connected to the facing surface part and extending in a direction perpendicular to a vibration direction of the facing surface part.

7. The transducer device according to any one of claims 1, 4, and 5, further comprising a bracket connected to the facing surface part and extending in a direction parallel to a vibration direction of the facing surface part.

8. The transducer device according to any one of claims 1 to 7, wherein the case
has a first opening in a direction coincident with the sandwiching direction and a second opening adjacent to the first opening in a direction perpendicular to the sandwiching direction, and
is able to support the support part so that the facing surface part is positioned at the first opening and able to support the support part so that the facing surface part is positioned at the second opening.

9. The transducer device according to claim 8, wherein the elastic bodies include:
first elastic bodies which sandwich the transducer element from the two sides in the first sandwiching direction coincident with the reference direction; and
second elastic bodies which sandwich the transducer element from two sides in the second sandwiching direction perpendicular to the reference direction, and
the facing surface part compresses the first elastic bodies in the first sandwiching direction coincident with the reference direction when the facing surface part is positioned at the first opening, and compresses the second elastic bodies in the second sandwiching direction perpendicular to the reference direction when the facing surface part is positioned at the second opening.

10. The transducer device according to any one of claims 1 to 9, wherein the elastic plate member comprises:
a pair of the support parts supported by the case;
the facing surface part; and
a pair of the elastic deformation parts connecting each of the pair of the support parts and the facing surface part.

11. The transducer device according to any one of claims 1 to 10, further comprising a pair of end portion electrodes disposed on the two sides of the transducer element and accommodated in the accommodating part of the case in a direction perpendicular to the reference direction and perpendicular to the sandwiching direction by the elastic bodies.

12. The transducer device according to claim 11, wherein the transducer unit, the case, and the pair of end portion electrodes constitute an integrally formed unit.

13. A transducer device comprising:
a transducer element formed by laminating a first electrode, one of a dielectric body or a piezoelectric body, and a second electrode in a predetermined reference direction;
elastic bodies sandwiching the transducer element from two sides in a first sandwiching direction which is a direction coincident with the reference direction and having an elastic modulus smaller than that of the transducer element in the first sandwiching direction;
a case including an accommodating part which accommodates a transducer unit having the transducer element and the elastic bodies, and an opening in the first sandwiching direction of the transducer unit; and
an elastic plate member including an elastic deformation part extending in a direction perpendicular to the reference direction from a side surface of the case, and a connecting part connected to a target device at an end portion in an extending direction of the elastic deformation part,
wherein a surface of the transducer unit exposed in an opening direction of the case from the opening of the case is disposed in contact with a facing part of the target device,
the facing part of the target device is made to function as an input/output member by being moved relative to the case by deformation of the elastic deformation part of the elastic plate member,
the facing part of the target device is made to function as an output member which outputs vibration of the transducer element via the elastic bodies when the transducer element functions as an actuator, and
the facing part of the target device is made to function as an input member which inputs vibration of the target device to the transducer element via the elastic bodies when the transducer element functions as a sensor.

14. The transducer device according to claim 13, wherein the transducer unit is compressed in the first sandwiching direction by the facing part of the target device in an initial state in which the target device is connected to the connecting part of the elastic plate member.

15. The transducer device according to claim 13 and 14, further comprising a pair of the elastic plate members which include:
a pair of the elastic deformation parts each extending in a direction perpendicular to the reference direction from two side surfaces of the case facing each other; and
a pair of the connecting parts connected to the target device at each of end portions in an extending direction of the pair of the elastic deformation parts.

16. The transducer device according to any one of claims 13 to 15, further comprising:
a pair of electrode terminals disposed in the accommodating part of the case and respectively electrically connected to the first electrode and the second electrode, wherein
the pair of electrode terminals extend from the accommodating part of the case to an outer surface of the case and are exposed on the outer surface of the case.

17. A transducer system comprising:
a plurality of sensors which detects an operation state of a target device;
a plurality of actuator devices which is the transducer device according to any one of claims 1 to 12, causes the transducer element to function as an actuator, respectively associated with the plurality of sensors, and the facing surface part of the elastic plate member is attached to the target device;
a drive circuit which is able to drive the plurality of actuator devices;
a switching unit which connects the drive circuit to a part of the plurality of actuator devices and switches an object to be connected to the drive circuit; and
a control unit which selects the actuator device to be connected to the drive circuit based on detection results of the plurality of sensors and controls the switching unit to connect the drive circuit to the selected actuator device.

18. The transducer system according to claim 17, wherein
the part of the plurality of actuator devices is the transducer device according to claim 2 or 3, and
the other part of the plurality of actuator devices is the transducer device according to claim 4 or 5.

19. A transducer system comprising:
a plurality of sensors which detects an operation state of a target device;
a plurality of actuator devices which is the transducer device according to any one of claims 13 to 16, causes the transducer element to function as an actuator, respectively associated with the plurality of sensors, and the elastic plate member is attached to the target device;
a drive circuit which is able to drive the plurality of actuator devices;
a switching unit which connects the drive circuit to a part of the plurality of actuator devices and switches an object to be connected to the drive circuit; and
a control unit which selects the actuator device to be connected to the drive circuit based on detection results of the plurality of sensors and controls the switching unit to connect the drive circuit to the selected actuator device.
